# EUROPEAN PATENT SPECIFICATION

(11) **EP 2 680 320 B1**
(45) Date of publication and mention of the grant of the patent: **13.08.2014**
(21) Application number: 12191952.6
(22) Date of filing: 09.11.2012
(51) Int. Cl.: H01L 31/048

(54) **Thin film solar cell module and method of manufacturing the same**
Dünnschicht-Solarzellenmodul und Verfahren zu dessen Herstellung
Module de cellules solaires en couches minces et son procédé de fabrication

(30) Priority: 28.06.2012 US 201261665736 P; 02.10.2012 US 201213633824
(43) Date of publication of application: 01.01.2014
(73) Proprietor: Samsung SDI Co., Ltd., Yongin-si, Gyeonggi-do (KR)
(72) Inventor: Ahn, Young-Kyoung, Chungcheognam-do (KR); Yang, Jung-Yup, Chungcheongnam-do (KR); Park, Bong-Kyoung, Chungcheongnam-do (KR); Lebedev, Yury, Chungcheongnam-do (KR)
(74) Representative: Mounteney, Simon James

(56) References cited:
- EP-A2- 2 413 371
- EP-A2- 2 595 200
- US-A1- 2004 244 827

## Description

The present invention relates to a thin film solar cell module and a method of manufacturing the same. Documents EP 2595200 A and EP241337 A describe color modules.

Currently, the depletion of existing energy resources such as oil or coal is expected to continue and thus interest in alternative sources of energy has increased. From among these alternative sources, solar cells for directly transforming solar energy into electric energy by using semiconductor elements are regarded as next-generation battery cells.

Solar cells use a p-n junction and utilize various devices, such as monocrystalline solar cell, polycrystalline solar cell, amorphous silicon solar cell, compounds solar cell, dye-sensitized solar cell, etc., according to their materials, to improve efficiency and characteristics. Among these solar cells, widely utilized crystalline silicon solar cells have high cost materials and involve complicated processing, compared to power generation efficiency. Thus, to avoid the problems associated with crystalline silicon solar cells, interest in thin film solar cells having low cost of production has increased.

Thin film solar cell modules include thin film solar cells, and generally additionally include edge sealing between a lower substrate and a cover substrate so as to protect thin film solar cells from external moisture, etc. However, the provision of edge sealing increases manufacturing complexity and cost.

The present invention sets out to provide a thin film solar cell module capable of preventing external moisture from penetrating even when edge sealing is omitted and a method of manufacturing the same.
Accordingly, the invention provides a thin film solar cell module as set out in claim 1. Preferred features of the invention are set out in claims 2 to 13.

According to an embodiment of the present invention, even when edge sealing is omitted, moisture can be prevented from penetrating into a thin film solar cell module.

Furthermore, because edge sealing is omitted, the process of manufacturing a thin film solar cell module can be further simplified.
FIG. 1 is a schematic cross-sectional view of a thin film solar cell module according to an embodiment of the present invention; and
FIGS. 2 through 8 are cross-sectional views for explaining a method of manufacturing the thin film solar cell module of FIG. 1.

Reference will now be made in detail to embodiments of the invention, examples of which are illustrated in the accompanying drawings, wherein like reference numerals refer to the like elements throughout.

The elements are exaggerated, omitted or schematically illustrated for convenience and clarity of description, and sizes thereof do not fully reflect actual sizes. Also, in the description of the elements, in the case where an element is referred to as being "on" or "under" another element, the element may be "directly" or "indirectly" on or under the other element or intervening elements. The term "on" or "under" is described with respect to the drawings.

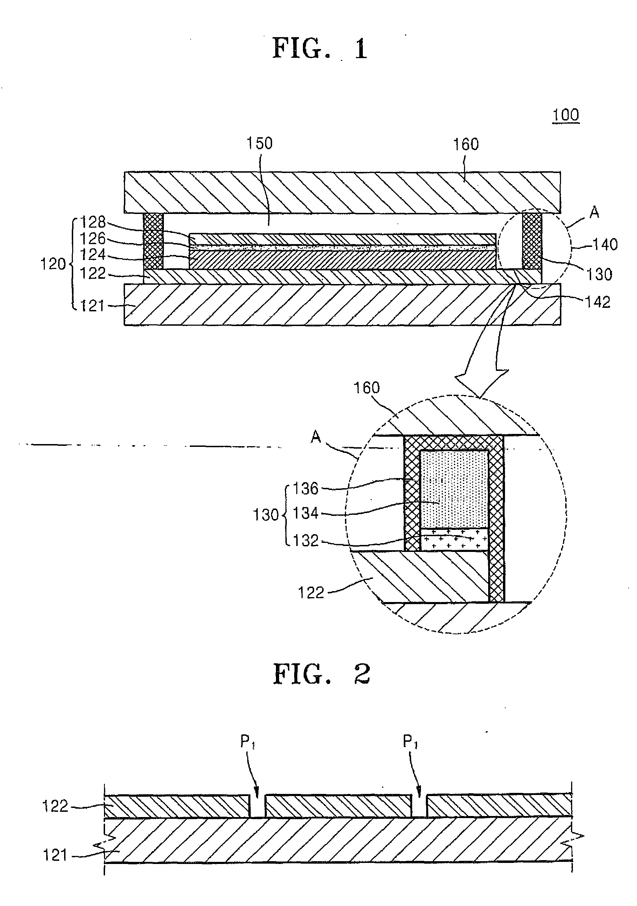

FIG. 1 is a schematic cross-sectional view of a thin film solar cell module 100 according to an embodiment of the present invention.

Referring to FIG. 1, the thin film solar cell module 100 includes a thin film solar cell 120, a pair of conductive members in the form of conductive tapes 130 attached to both ends of the thin film solar cell 120, an encapsulation layer 150 that seals the thin film solar cell 120, and a cover substrate 160. Although conductive tapes are used in this embodiment, other forms of conductive member may be used.

The thin film solar cell 120 is a device that directly transforms solar light energy into electric energy by using a photoelectric effect and may be a CIGS thin film solar cell, an amorphous silicone thin film solar cell, a CdTd thin film solar cell, etc. Although the thin film solar cell 120 is hereinafter referred to as the CIGS thin film solar cell, the present invention is not limited thereto. The thin film solar cell 120 may be the amorphous silicone thin film solar cell or the CdTd thin film solar cell.

The thin film solar cell 120 includes a lower substrate 121, and a rear electrode layer 122, a light absorption layer 124, a buffer layer 126, and a transparent electrode layer 128 that are sequentially stacked on the lower substrate 121.

The lower substrate 121 may be a glass substrate or a polymer substrate, etc. For example, the glass substrate may use soda lime glass or high-strain point soda glass, and the polymer substrate may use polyimide. However, the present invention is not limited thereto.

The rear electrode layer 122 may be formed of a metallic material having excellent conductivity and light reflectivity such as molybdenum (Mo), aluminum (Al) or copper (Cu) in order to collect charges formed by the photoelectric effect and reflect light that transmits the light absorption layer 124 to allow the light absorption layer 124 to reabsorb the light. In particular, the rear electrode layer 122 may be formed of molybdenum (Mo) in consideration of high conductivity, an ohmic contact with the light absorption layer 124, a high temperature stability at an atmosphere of selenium (Se), etc. Also, the rear electrode layer 122 may be formed as a multilayer so as to secure a junction with the lower substrate 121 and a resistance characteristic of the rear electrode layer 122.

The light absorption layer 124 may be formed of a copper-indium-gallium-selenide (Cu(In,Ga)Se₂,CIGS)-based compound including copper (Cu), indium (In), gallium (Ga), and selenide (Se) to form a P type semiconductor layer, and absorbs incident solar light. The light absorption layer 124 may be formed having a thickness between about 0.7 µm and about 2 µm in various ways.

The buffer layer 126 reduces a band gap difference between the light absorption layer 124 and the transparent electrode layer 128 that will be described later, and reduces recombination of electrons and holes that may occur on an interface between the light absorption layer 124 and the transparent electrode layer 128. The buffer layer 126 may be formed of CdS, ZnS, In₂S₃, ZnₓMg₍₁₋ₓ₎O, etc. In some embodiments it may be omitted.

The transparent electrode layer 128 constitutes a P-N junction and is formed of a conductive material having a property capable of transmitting light such as ZnO:B, ITO or IZO, etc. Thus, the transparent electrode layer 128 may transmit incident light and simultaneously collect charges formed by the photoelectric effect.

The pair of conductive tapes 130 are attached onto the rear electrode layer 122 having a top surface exposed at both sides of the thin film solar cell 120. The pair of conductive tapes 130 collect electrons and holes that occur in the thin film solar cell 120, and are electrically connected to a junction box (not shown) that prevents a counter flow of current. Also, the pair of conductive tapes 130 serve to seal the thin film solar cell 100 to prevent external moisture from penetrating into the thin film solar cell module 100. That is, the pair of conductive tapes 130 may simultaneously act as a ribbon and perform edge sealing.

Meanwhile, referring to a part A of FIG. 1 that is a magnification of an edge region 140 of the solar cell module, the pair of conductive tapes 130 each include a first adhesive layer 132, an electrically conductive layer 134 disposed on the first adhesive layer 132, and a second adhesive layer 136 that surrounds the first adhesive layer 132 and the electrically conductive layer 134. In this embodiment, the electrically conductive layer 134 is formed from metal.

The first adhesive layer 132 bonds the rear electrode layer 122 and the metal layer 134 to each other in an extension portion 142 of the first electrode layer, and exhibits conductivity in such a way that charges may move from the rear electrode layer 122 to the metal layer 134. The first adhesive layer 132 may be formed by dispersing conductive particles formed of gold, silver, nickel, copper, etc. having excellent conductivity into an adhesive film formed of epoxy resin, acrylic resin, polyimide resin, polycarbonate resin, etc. Conductive particles that are dispersed in the adhesive film may be exposed to the outside of the adhesive film by processing such as laminating and may be used to electrically connect the rear electrode layer 122 and the metal layer 134.

The metal layer 134 may be a main path through which collected charges move and may be formed by coating a metal layer formed of copper, gold, silver, nickel, etc. with tin, etc.

The second adhesive layer 136 may be formed of butyl resin, acrylic resin, epoxy resin, phenoxy resin, etc. having excellent adhesion and low moisture penetration and may be used to attach the metal layer 134 and the cover substrate 160 to each other, thereby sealing the thin film solar cell module 100 and preventing external moisture from penetrating into the thin film solar cell module 100.

Meanwhile, the second adhesive layer 136 is formed to surround the first adhesive layer 132 and the metal layer 134 and acts as a barrier layer. More specifically, the second adhesive layer 136 may be formed on exterior surfaces of the metal layer 134, the first adhesive layer 132, and the lower electrode layer 122 and interior surfaces of the first metal layer 134 and the first adhesive layer 132.

As described above, the second adhesive layer 136 is formed on the exterior surfaces of the metal layer 134, the first adhesive layer 132, and the lower electrode layer 122, act as a barrier layer, thereby preventing the metal layer 134, the first adhesive layer 132, and the lower electrode layer 122 from being corroded due to exposure to an external environment. Also, the second adhesive layer 136 is formed on the interior surfaces of the first metal layer 134 and the first adhesive layer 132, thereby preventing external moisture from penetrating into the thin film solar cell module 100 secondarily.

The encapsulation layer 150 may be disposed between the pair of conductive tapes 130 and seal the thin film solar cell 120, together with the pair of conductive tapes 130, thereby blocking moisture or oxygen that may adversely affect the thin film solar cell 120.

The encapsulation layer 150 may be formed of ethylene vinyl acetate (EVA) copolymer resin, polyvinyl butyral (PVB), EVA partial oxide, silicon resin, ester-based resin, olefin-based resin, etc. However, the present invention is not limited thereto,

The cover substrate 160 may be formed of glass in such a way that sun light may be transmitted through the cover substrate 160, and may be further formed of tempered glass so as to protect the thin film solar cell 120 from an external shock, etc. Also, the cover substrate 160 may be further formed of low iron tempered glass so as to prevent solar light from being reflected and increase transmittance of solar light.

FIGS. 2 through 8 are cross-sectional views for explaining a method of manufacturing the thin film solar cell module 100 of FIG. 1.

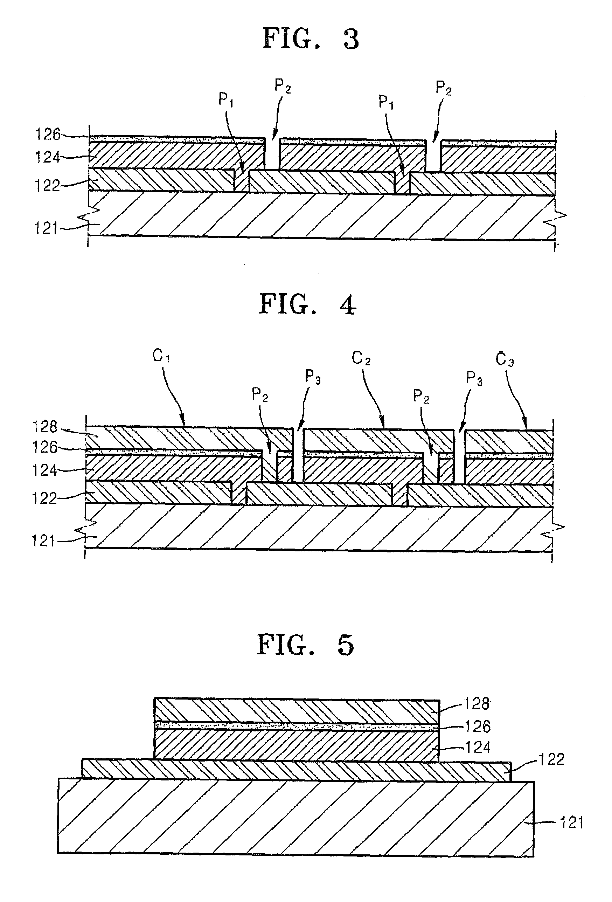

FIGS. 2 through 4 are detailed views of a structure of the thin film solar cell 120 and the method of manufacturing the thin film solar cell module 100 of FIG. 1 as well. FIGS. 5 through 8 are views for explaining the method of manufacturing the thin film solar cell module 100 by using the thin film solar cell 120 manufactured in FIGS. 2 through 4.

A method of manufacturing the thin film solar cell 120 will now be described with reference to FIGS. 2 through 4.

Referring to FIG. 2, the rear electrode layer 122 is formed on the lower substrate 121 as a whole, first patterning is performed thereon, and the rear electrode layer 122 is split into a plurality of layers.

The rear electrode layer 122 may be formed by applying a conductive paste on the lower substrate 121 and thermally processing the conductive paste or through processing such as plating. Also, the rear electrode layer 122 may be formed through sputtering using a molybdenum (Mo) target.

The first patterning may use, for example, laser scribing. The laser scribing is performed by irradiating a laser from a bottom surface of the lower substrate 121 to the lower substrate 121 and evaporating a part of the rear electrode layer 122, and thus a first pattern portion P1 that splits the rear electrode layer 122 into the plurality of layers with uniform gaps therebetween may be formed.

Thereafter, referring to FIG. 3, the light absorption layer 124 and the buffer layer 126 are formed and then second patterning is performed thereon.

The light absorption layer 124 may be formed using i) a co-evaporation method of heating copper (Cu), indium (In), gallium (Ga), and selenium (Se) contained in a small electric furnace installed in a vacuum chamber and performing vacuum and evaporation thereon, and ii) a sputtering/selenization method of forming a CIG-based metal precursor layer on the rear electrode layer 122 by using a copper (Cu) target, an indium (In) target, and a gallium (Ga) target, thermally processing the CIG-based metal precursor layer in an atmosphere of hydrogen selenide (H₂Se), and reacting the CIG-based metal precursor layer with selenium (Se). Also, the light absorption layer 124 may be formed using an electro-deposition method, a molecular organic chemical vapor deposition (MOCVD) method, etc.

The buffer layer 126 may be formed using a chemical bath deposition (CBD) method, an atomic layer deposition (ALD) method, an ion layer gas reaction (ILGAR) method, etc.

The second patterning may use, for example, mechanical scribing that is performed to form a second pattern portion P2 by moving a sharp tool such as a needle in a direction parallel to the first pattern portion P1 at a point spaced apart from the first pattern portion P1. However, the present invention is not limited thereto. For example, the second patterning may use laser scribing.

The second pattern portion P2 splits the light absorption layer 124 into a plurality of layers and extends to a top surface of the rear electrode layer 122 to allow the rear electrode layer 122 to be exposed.

Referring to FIG. 4, after the transparent electrode layer 128 is formed, third patterning is performed.

The transparent electrode layer 128 may be formed of a transparent and conductive material such as ZnO:B, ITO or IZO, etc., and may be formed using a metalorganic chemical vapor deposition (MOCVD), a low pressure chemical vapor deposition (LPCVD), or a sputtering method, etc.

The transparent electrode layer 128 is formed in the second pattern portion P2 to contact the rear electrode layer 122 exposed by the second pattern portion P2 and electrically connect the light absorption layer 124 that are split into the plurality of layers by the second pattern portion P2.

The transparent electrode layer 128 may be split into a plurality of layers by a third pattern portion P3 formed at a location different from the first pattern portion P1 and the second pattern portion P2.

The third patterning may use mechanical scribing. The third pattern portion P3 formed by performing the third patterning may be a groove formed in parallel with the first pattern portion P1 and the second pattern portion P2, extend to the top surface of the rear electrode layer 121, and thus a plurality of photoelectric conversion units C1~C3 may be formed. Also, the third pattern portion P3 may act as an insulation layer between the photoelectric conversion units C1~C3 to connect the photoelectric conversion units C1~C3 in series with each other.

The method of manufacturing the thin film solar cell module 100 of FIG. 1 will now be described with reference to FIGS. 5 through 8.

Referring to FIG. 5, edge deletion is performed on the thin film solar cell 120 of FIG. 4, and then the top surface of the extension portion 142 of the rear electrode layer 122 is exposed to attach the pair of conductive tapes 130 thereto.

The edge deletion is a process of removing the rear electrode layer 122, the light absorption layer 124, the buffer layer 126, and the transparent electrode layer 128 formed on edges of the lower substrate 121, and thus a bonding force between the encapsulation layer 124 and the lower substrate 121 may be enhanced. The edge deletion may be performed using mechanical scribing or laser scribing.

After the edge deletion is performed, the extension portions 142 of the rear electrode layer 122 are exposed through mechanical scribing, laser scribing, or selective etching. The pair of conductive tapes 130 are attached onto the exposed rear electrode layer 122, and thus a width of the exposed rear electrode layer 122 may be greater than that of the pair of conductive tapes 130 in consideration of a processing error, etc.

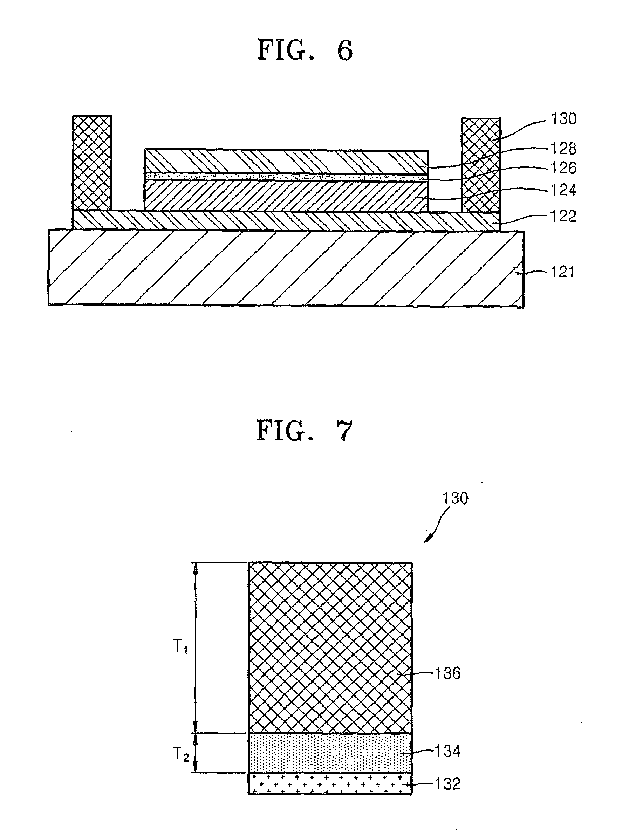

Thereafter, referring to FIG. 6, the pair of conductive tapes 130 are attached onto the exposed top surface of the rear electrode layer 122. The pair of conductive tapes 130 may be disposed extending in a direction of one side of the rear electrode layer 1122 in parallel with the first through third pattern portions P1 through P3. Also, although not shown, the pair of conductive tapes 130 may have a shape "¬" so as to seal the thin film solar cell module 100 having an oblong shape as a whole.

Meanwhile, FIG. 7 is a cross-sectional view of the pair of conductive tapes 130 attached onto the rear electrode layer 122. Referring to FIG. 7, the pair of conductive tapes 130 each include the first adhesive layer 132, the metal layer 134, and the second adhesive layer 136 that are sequentially stacked. A thickness T₁ of the second adhesive layer 136 may be five through ten times greater than a thickness T₂ of the metal layer 134.

As will be described later, at least a part of the second adhesive layer 136 melts during laminating and flows down along side surfaces of the metal layer 134 and the first adhesive layer 132 located under the second adhesive layer 136, and thus the second adhesive layer 136 covers the side surfaces of the metal layer 134 and the first adhesive layer 132 to form a barrier layer. Therefore, the metal layer 134 and the second adhesive layer 132 are blocked from an external environment, thereby preventing the metal layer 134 and the second adhesive layer 132 from being corroded and effectively preventing external moisture from penetrating into the thin film solar cell module 100.

However, in a case where the thickness T₁ of the second adhesive layer 136 is five times smaller than the thickness T₂ of the metal layer 134, the second adhesive layer 136 might not in certain cases sufficiently cover the side surfaces of the metal layer 134 and the second adhesive layer 132 during laminating, and thus the metal layer 134 and the second adhesive layer 132 are exposed to the outside, which may corrode the metal layer 134 and the second adhesive layer 132 and not prevent external moisture from penetrating into the thin film solar cell module 100.

Meanwhile, in a case where the thickness T₁ of the second adhesive layer 136 is ten times greater than the thickness T₂ of the metal layer 134, since the thickness of the pair of conductive tapes 130 is very great, the second adhesive layer 136 that melts during laminating might, in certain cases, penetrate into a top surface of the encapsulation layer 150. In this case, a bonding force between the encapsulation layer 150 and the cover substrate 160 is weakened, which deteriorates a sealing effect, and incident light is partially blocked by the second adhesive layer 136, which reduces efficiency of the thin film solar cell module 100.

Therefore, the thickness T₁ of the second adhesive layer 136 may be five through ten times greater than the thickness T₂ of the metal layer 134.

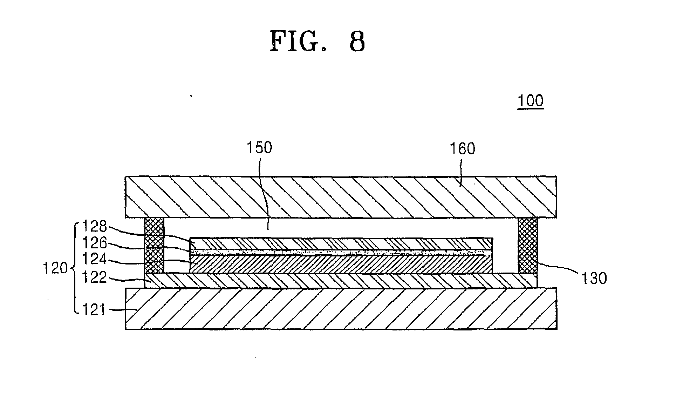

After the pair of conductive tapes 130 is attached onto the rear electrode layer 122, referring to FIG. 8, the encapsulation layer 150 and the cover substrate 160 may be disposed to form the thin film solar cell module 100 through laminating.

The encapsulation layer 150 is disposed between the pair of conductive tapes 130 and seals the thin film solar cell module 100 through laminating.

Meanwhile, at least a part of the second adhesive layer 136 melts during laminating and flows down along the side surfaces of the metal layer 134 and the first adhesive layer 132 by the force of gravity, and thus the second adhesive layer 136 is formed to surround the first adhesive layer 132 and the metal layer 134. Therefore, the metal layer 134 and the second adhesive layer 132 are blocked from an external environment, thereby preventing the metal layer 134 and the second adhesive layer 132 from being corroded and effectively preventing external moisture from penetrating into the thin film solar cell module 100.

That is, according to the one or more of the above embodiments of the present invention, the pair of conductive tapes 130 simultaneously act as a ribbon and performs edge sealing, and thus edge sealing may be omitted. Furthermore, edge sealing is not performed, and thus a process of manufacturing the thin film solar cell module 100 may be further simplified. Furthermore, since edge sealing is not performed, an area of the thin film solar cell 120 may increase, thereby enhancing photoelectric conversion efficiency of the thin film solar cell module 100.

## Claims

1. A thin film solar cell module (100) comprising:
a first substrate (121);
a first electrode layer (122) over the first substrate (121);
a light absorption layer (124) over the first electrode layer (122);
a second electrode layer (128) over the light absorption layer (124); and
a second substrate (160) over the second electrode layer (128);
wherein an edge region (140) is located between the first and second substrates (121, 160) and an encapsulation layer (150) is provided between the said first and second substrates (121, 160) in at least the said edge region (140);
wherein the thin film solar cell module (100) further comprises an electrically conductive member (130) situated in the said edge region (140), the said electrically conductive member (130) forming an edge seal extending at least a part of the way between the first and second substrates (121, 160),
wherein the said electrically conductive member (130) comprises an electrically conductive layer (134),
and, wherein a portion of the first electrode layer (122) extends laterally beyond the light absorption layer (124) into the edge region (140) to form an extension portion (142) and the electrically conductive member (130) is situated over the extension portion (142).

2. A thin film solar cell module (100) according to claim 1, wherein the electrically conductive member (130) comprises an electrically conductive contact layer (132) situated between the extension portion (142) and the electrically conductive layer (134) and forming an electrical contact therebetween.

3. A thin film solar cell module (100) according to claim 2, wherein the contact layer (132) comprises a first adhesive layer (132)

4. A thin film solar cell module (100) according to one of claims 1 to 3, wherein the said electrically conductive member (130) comprises a barrier layer (136).

5. A thin film solar cell module (100) according to claim 4, wherein the barrier layer (136) extends between the first and second substrates (121, 160).

6. A thin film solar cell module according to claim 4 or 5, wherein the barrier layer (136) surrounds the electrically conductive layer (134) on at least a laterally inner side and a laterally outer side thereof.

7. A thin film solar cell module (100) according to claim 4, 5 or 6, wherein the barrier layer (136) extends between the electrically conductive layer (134) and the second substrate (160).

8. A thin film solar cell module (100) according to claim 4, 5, 6 or 7 wherein the barrier layer (136) at least partly covers an edge portion of the first electrode layer (122).

9. A thin film solar cell module (100) according to one of claims 4 to 8, wherein the barrier layer (136) comprises a second adhesive layer (136).

10. A thin film solar cell module (100) according to claim 9, wherein the second adhesive layer (136) comprises butyl resin, acrylic resin, epoxy resin or phenoxy resin.

11. A thin film solar cell module (100) according to one of claims 4 to 10. when dependent upon claim 4, wherein the said electrically conductive member is a conductive tape (130).

12. A thin film solar cell module (100) according to any preceding claim, further comprising a buffer layer (126) over the light absorption layer (124); the said first and second electrodes (121, 160), the light absorption layer (124) and the buffer layer (126) together forming a thin film solar cell (120).

13. A thin film solar cell module (100) according to claim 12 when dependent upon claim 11, wherein the said conductive tape (130) is adapted to collect electrons and holes that occur in the thin film solar cell (120) and is electrically connected to a junction box.

## Patentansprüche

1. Dünnschicht-Solarzellenmodul (100), umfassend:
ein erstes Substrat (121);
eine erste Elektrodenschicht (122) über dem ersten Substrat (121);
eine Lichtabsorptionsschicht (124) über der ersten Elektrodenschicht (122);
eine zweite Elektrodenschicht (128) über der Lichtabsorptionsschicht (124); und
ein zweites Substrat (160) über der zweiten Elektrodenschicht (128);
wobei ein Randbereich (140) zwischen dem ersten und zweiten Substrat (121, 160) angeordnet ist und eine Kapselungsschicht (150) zwischen dem ersten und zweiten Substrat (121, 160) in mindestens dem Randbereich (140) vorgesehen ist;
wobei das Dünnschicht-Solarzellenmodul (100) ferner ein elektrisch leitfähiges Teil (130) aufweist, das sich in dem Randbereich (140) befindet, wobei das elektrisch leitfähige Teil (130) eine Randdichtung bildet, die sich mindestens über einen Teil des Weges zwischen dem ersten und zweiten Substrat (121, 160) erstreckt,
wobei das elektrisch leitfähige Teil (130) eine elektrisch leitfähige Schicht (134) umfasst;
und wobei ein Abschnitt der ersten Elektrodenschicht (122) sich seitlich über die Lichtabsorptionsschicht (124) hinaus in den Randbereich (140) erstreckt, um einen Verlängerungsabschnitt (142) zu bilden, und das elektrisch leitfähige Teil (130) sich über dem Verlängerungsabschnitt (142) befindet.

2. Dünnschicht-Solarzellenmodul (100) nach Anspruch 1, wobei das elektrisch leitfähige Teil (130) eine elektrisch leitfähige Kontaktschicht (132) aufweist, die sich zwischen dem Verlängerungsabschnitt (142) und der elektrisch leitfähigen Schicht (134) befindet und einen elektrischen Kontakt zwischen ihnen bildet.

3. Dünnschicht-Solarzellenmodul (100) nach Anspruch 2, wobei die Kontaktschicht (132) eine erste Klebstoffschicht (132) umfasst.

4. Dünnschicht-Solarzellenmodul (100) nach einem der Ansprüche 1 bis 3, wobei das elektrisch leitfähige Teil (130) eine Sperrschicht (136) umfasst.

5. Dünnschicht-Solarzellenmodul (100) nach Anspruch 4, wobei die Sperrschicht (136) sich zwischen dem ersten und zweiten Substrat (121, 160) erstreckt.

6. Dünnschicht-Solarzellenmodul nach Anspruch 4 oder 5, wobei die Sperrschicht (136) die elektrisch leitfähige Schicht (134) auf zumindest ihrer seitlich inneren Seite und seitlich äußeren Seite umgibt.

7. Dünnschicht-Solarzellenmodul (100) nach Anspruch 4, 5 oder 6, wobei die Sperrschicht (136) sich zwischen der elektrisch leitfähigen Schicht (134) und dem zweiten Substrat (160) erstreckt.

8. Dünnschicht-Solarzellenmodul (100) nach Anspruch 4, 5, 6 oder 7, wobei die Sperrschicht (136) einen Randabschnitt der ersten Elektrodenschicht (122) mindestens teilweise überdeckt.

9. Dünnschicht-Solarzellenmodul (100) nach einem der Ansprüche 4 bis 8, wobei die Sperrschicht (136) eine zweite Klebstoffschicht (136) umfasst.

10. Dünnschicht-Solarzellenmodul (100) nach Anspruch 9, wobei die zweite Klebstoffschicht (136) Butylharz, Acrylharz, Epoxidharz oder Phenoxyharz umfasst.

11. Dünnschicht-Solarzellenmodul (100) nach einem der Ansprüche 4 bis 10 bei Abhängigkeit von Anspruch 4, wobei das elektrisch leitfähige Teil ein leitfähiges Band (130) ist.

12. Dünnschicht-Solarzellenmodul (100) nach einem der vorhergehenden Ansprüche, ferner umfassend eine Pufferschicht (126) über der Lichtabsorptionsschicht (124); wobei die erste und zweite Elektrode (121, 160), die Lichtabsorptionsschicht (124) und die Pufferschicht (126) zusammen eine Dünnschicht-Solarzelle (120) bilden.

13. Dünnschicht-Solarzellenmodul (100) nach Anspruch 12 bei Abhängigkeit von Anspruch 11, wobei das leitfähige Band (130) dafür eingerichtet ist, Elektronen und Löcher, die in der Dünnschicht-Solarzelle (120) auftreten, zu sammeln, und an eine Anschlussdose elektrisch angeschlossen ist.

## Revendications

1. Module de cellules solaires à couches minces (100) comprenant :
un premier substrat (121) ;
une première couche d'électrode (122) sur le premier substrat (121) ;
une couche d'absorption de lumière (124) sur la première couche d'électrode (122) ;
une deuxième couche d'électrode (128) sur la couche d'absorption de lumière (124) ; et
un deuxième substrat (160) sur la deuxième couche d'électrode (128) ;
dans lequel une région de bord (140) est située entre les premier et deuxième substrats (121, 160) et une couche d'encapsulation (150) est prévue entre lesdits premier et deuxième substrats (121, 160) au moins dans ladite région de bord (140) ;
dans lequel le module de cellules solaires à couches minces (100) comprend en outre un élément électriquement conducteur (130) situé dans ladite région de bord (140), ledit élément électriquement conducteur (130) formant un joint de bord s'étendant sur au moins une partie du trajet entre les premier et deuxième substrats (121, 160),
dans lequel ledit élément électriquement conducteur (130) comprend une couche électriquement conductrice (134),
et dans lequel une partie de la première couche d'électrode (122) s'étend latéralement au-delà de la couche d'absorption de lumière (124) dans la région de bord (140) pour former une partie d'extension (142) et l'élément électriquement conducteur (130) est situé sur la partie d'extension (142).

2. Module de cellules solaires à couches minces (100) selon la revendication 1, dans lequel l'élément électriquement conducteur (130) comprend une couche de contact électriquement conductrice (132) située entre la partie d'extension (142) et la couche électriquement conductrice (134) et formant un contact électrique entre elles.

3. Module de cellules solaires à couches minces (100) selon la revendication 2, dans lequel la couche de contact (132) comprend une première couche adhésive (132).

4. Module de cellules solaires à couches minces (100) selon l'une des revendications 1 à 3, dans lequel ledit élément électriquement conducteur (130) comprend une couche de barrière (136).

5. Module de cellules solaires à couches minces (100) selon la revendication 4, dans lequel la couche de barrière (136) s'étend entre les premier et deuxième substrats (121, 160).

6. Module de cellules solaires à couches minces selon la revendication 4 ou 5, dans lequel la couche de barrière (136) entoure la couche électriquement conductrice (134) au moins d'un côté latéralement intérieur et d'un côté latéralement extérieur de celle-ci.

7. Module de cellules solaires à couches minces (100) selon la revendication 4, 5 ou 6, dans lequel la couche de barrière (136) s'étend entre la couche électriquement conductrice (134) et le deuxième substrat (160).

8. Module de cellules solaires à couches minces (100) selon la revendication 4, 5, 6 ou 7, dans lequel la couche de barrière (136) recouvre au moins partiellement une partie de bord de la première couche d'électrode (122).

9. Module de cellules solaires à couches minces (100) selon l'une des revendications 4 à 8, dans lequel la couche de barrière (136) comprend une deuxième couche adhésive (136).

10. Module de cellules solaires à couches minces (100) selon la revendication 9, dans lequel la deuxième couche adhésive (136) comprend une résine butylique, une résine acrylique, une résine époxy ou une résine à radical phénoxy.

11. Module de cellules solaires à couches minces (100) selon l'une des revendications 4 à 10 lorsqu'elles dépendent de la revendication 4, dans lequel ledit élément électriquement conducteur est une bande conductrice (130).

12. Module de cellules solaires à couches minces (100) selon l'une quelconque des revendications précédentes, comprenant en outre une couche tampon (126) sur la couche d'absorption de lumière (124) ; lesdites première et deuxième électrodes (121, 160), la couche d'absorption de lumière (124) et la couche tampon (126) formant, ensemble, une cellule solaire à couches minces (120).

13. Module de cellules solaires à couches minces (100) selon la revendication 12, lorsqu'elle dépend de la revendication 11, dans lequel ladite bande conductrice (130) est conçue pour collecter les électrons et les trous qui apparaissent dans la cellule solaire à couches minces (120) et est connectée électriquement à une boîte de jonction.
